# EUROPÄISCHE PATENTSCHRIFT

(11) **EP 2 745 402 B1**
(45) Veröffentlichungstag und Bekanntmachung des Hinweises auf die Patenterteilung: **10.08.2016**
(21) Anmeldenummer: 12751265.5
(22) Anmeldetag: 16.08.2012
(51) Int. Cl.: H03K 17/945, B60J 5/04

(54) **TÜRMODUL MIT INTEGRIERTER SENSORELEKTRODE**
DOOR MODULE WITH INTEGRATED SENSOR
MODULE DE PORTE AVEC CAPTEUR INTÉGRÉ

(30) Priorität: 20.08.2011 DE 102011111209
(43) Veröffentlichungstag der Anmeldung: 25.06.2014
(73) Patentinhaber: Brose Fahrzeugteile GmbH & Co. Kommanditgesellschaft, Bamberg, 96052 Bamberg (DE)
(72) Erfinder: ÜBELEIN, Jörg, 96271 Grub am Forst (DE); AYALA GUZMAN, Oscar, Mauricio, 96450 Coburg (DE); THOMANN, Christian, 96138 Burgebrach (DE); HERRMANN, Christian, 96450 Coburg (DE)
(74) Vertreter: FDST Patentanwälte
(86) Internationale Anmeldenummer: PCT/EP2012/003476
(87) Internationale Veröffentlichungsnummer: WO 2013/026546

(56) Entgegenhaltungen:
- EP-B1- 1 212 206
- DE-A1-102006 059 208
- DE-U1-202008 006 499

## Beschreibung

Die Erfindung bezieht sich auf ein Türmodul für eine (Seiten-)Tür eines Kraftfahrzeugs, mit einem Träger zur Aufnahme eines Fensterheberantriebs sowie mit Befestigungspunkten, an denen das Türmodul an der zugeordneten Tür befestigbar ist. Ein solches Türmodul ist beispielsweise aus EP 1 212 206 B1 bekannt.

Aus DE 20 2008 006 499 U1 ist ein weiteres Türmodul bekannt, an dessen Träger ein Crash-Sensor angebracht ist.

Aus DE 10 2006 059 208 A1 ist ferner ein kapazitiver Sensor zum berührungslosen Öffnen einer Fahrzeugtür bekannt. Der Sensor ist hierbei in einen Türgriff integriert.

Ein Türmodul wird bei modernen Kraftfahrzeugen üblicherweise zwischen den aus Blech bestehenden Türkörper und die Türinnenverkleidung eingesetzt. Der Träger eines solchen Türmoduls, bei dem es sich oft um ein großflächiges Kunststoffteil handelt, trägt zusätzlich zu dem Fensterheberantrieb häufig noch weitere Funktionskomponenten, insbesondere eine Steuerelektronik zur Ansteuerung des Fensterhebers. Des Weiteren hat ein solches Türmodul häufig Einbauöffnungen für Bordlautsprecher und dient zur Kabelführung für die innerhalb der Tür verlegten elektrischen Versorgungs- und Signalleitungen.

Der Einsatz eines Türmoduls hat insbesondere den Vorteil, dass das Türmodul mit allen darauf gehalterten Funktionskomponenten - beispielsweise durch einen Kraftfahrzeugzulieferer - vormontiert sowie optional auch verkabelt und geprüft werden kann. Das vormontierte Türmodul wird typischerweise bei der Endmontage des Kraftfahrzeugs im Ganzen an dem Türkörper befestigt, was die Endmontage des Kraftfahrzeugs signifikant vereinfacht und beschleunigt.

Allerdings wird der mittels eines solchen Türmoduls erzielbare Vorfertigungsgrad oft durch bauliche Gegebenheiten der Tür eingeschränkt. So können beispielsweise Bedientasten, wie sie zur Betätigung des Fensterhebers, zur Spiegelverstellung, etc. üblicherweise an der Tür vorgesehen sind, oft erst nach dem Einsetzen der Türinnenverkleidung montiert und mit den zugehörigen Funktionskomponenten am Türmodul elektrisch kontaktiert werden, was - insbesondere angesichts oft beengter Raumverhältnisse - mit nennenswertem Aufwand verbunden sein kann.

Der Erfindung liegt die Aufgabe zugrunde, die Fertigung einer Kraftfahrzeugtür noch effizienter zu gestalten.

Diese Aufgabe wird erfindungsgemäß gelöst durch Angabe eines Türmoduls mit den Merkmalen des Anspruchs 1. Danach umfasst das Türmodul einen Träger, der zumindest zur Aufnahme eines Fensterantriebs eingerichtet ist, oder an dem ein solcher Fensterheberantrieb bereits aufgenommen ist. Das Türmodul umfasst weiterhin Befestigungspunkte, an denen das Türmodul an der zugeordneten (Seiten-) Tür des Kraftfahrzeugs befestigbar oder bereits befestigt ist. Erfindungsgemäß ist nun an diesem Träger mindestens eine Sensorelektrode einer Steuereinrichtung an- oder eingebracht, die zur berührungslosen Betätigung eines Aktors in dem Kraftfahrzeug dient.

Mit "Aktor" ist allgemein ein Bauelement bezeichnet, dass eine Eingangsgröße in eine andersartige Ausgangsgröße umwandelt, um einen gewünschten Effekt hervorzurufen. Bei der Eingangsgröße handelt es sich hierbei insbesondere um ein elektronisches Steuersignal. Bei der Ausgangsgröße kann es sich um eine mechanische Bewegung handeln. In diesem Fall ist der Aktor beispielsweise durch einen Elektromotor gebildet oder umfasst zumindest einen solchen. Ein typisches Beispiel für einen solchen Aktor ist der an dem Träger gehalterte Fensterheberantrieb. Bei der Ausgangsgröße kann es sich aber auch um eine andere physikalische Größe, z.B. Druck, Temperatur, Fluidströmung, Ton oder Licht handeln.

Die Steuereinrichtung ist vorzugsweise als kapazitiver Näherungssensor ausgebildet, der die Annäherung eines Objekts (insbesondere eines Körperteils eines Fahrzeugnutzers) über die Wechselwirkung des Objekts mit einem von der Sensorelektrode erzeugten elektrischen Feld detektiert. Grundsätzlich ist im Rahmen der Erfindung aber möglich, eine Steuereinrichtung im Rahmen des Türmoduls vorzusehen, die auf einem induktiven (magnetischen) oder einem elektromagnetischen Detektionsprinzip beruht.

Die Erfindung geht hierbei von der Überlegung aus, dass es vorteilhaft ist, die üblicherweise im Rahmen einer (Seiten-)Tür eines Fahrzeugs als Bedienelemente für die Fensterscheibe, die Spiegelverstellung, etc. vorgesehenen elektromechanischen Schalter durch kapazitive und/oder induktive Näherungssensoren zu ersetzen. Ein Vorteil solcher Näherungssensoren besteht darin, dass diese Näherungssensoren berührungslos detektieren, d.h. ein befehlsgebendes Körperteil eines Fahrzeugnutzers bereits detektieren, wenn sich dieses Körperteil noch in einem (von Null verschiedenen) Abstand zu dem Näherungssensor (genauer einer Sensorelektrode desselben) befindet.

Diese Eigenschaft ermöglicht es erkanntermaßen, die als Bedienelement vorgesehene Sensorelektrode unter der Türinnenverkleidung zu "verstecken", nämlich an der vom Fahrzeuginnenraum abgewandten Rückseite der Türinnenraumverkleidung anzuordnen. Dies wiederum ermöglicht es erkanntermaßen, die Sensorelektrode bereits vor der Montage des Türmoduls an demselben anzubringen, wodurch eine weitere Effizienzsteigerung bei der Türmontage erzielt wird.

Um das Risiko zu vermindern, dass die Sensorelektrode vor oder während der Montage des Türmoduls beschädigt wird oder verrutscht, ist die Sensorelektrode vorzugsweise einstückig mit dem Träger verbunden. "Einstückig" bedeutet hierbei, dass die Sensorelektrode stoffschlüssig mit dem Träger verbunden ist und insbesondere nicht zerstörungsfrei von dem Träger trennbar ist.

Insbesondere ist die Sensorelektrode dabei in zweckmäßiger Ausgestaltung der Erfindung aus einer Folie oder einem Blech aus elektrisch leitfähigem Material, insbesondere einem Metall (z.B. Kupfer) gebildet, wobei diese Folie - z.B. durch Verschweißung, Prägung oder Verklebung - flächig auf dem Träger aufgebracht ist.

Alternativ hierzu kann die Sensorelektrode im Rahmen der Erfindung auch durch eine auf den Träger aufgebrachte, elektrisch leitfähige Beschichtung gebildet sein. Als "Beschichtung" wird hierbei eine Schicht bezeichnet, die - anders als bei einer Folie - nicht in festem Zustand, sondern in ursprünglich flüssigem oder gasförmigen Zustand auf die Oberfläche des Trägers aufgebracht wurde und sich dort verfestigt hat. In zweckmäßigen Verfahrensvarianten kann diese Beschichtung hierbei zum Beispiel durch Plasmabeschichtung, Aufdampfen, Sputtern oder Flammenspritzen hergestellt sein.

Wiederum alternativ hierzu kann die Sensorelektrode im Rahmen der Erfindung auch durch einen elektrisch leitfähigen Kunststoffbereich des Trägers, also ein elektrisch leitfähiges Teilvolumen des Trägers gebildet sein. Zur Herstellung der elektrischen Leitfähigkeit kann dem Kunststoffmaterial des Trägers lokal ein leitfähiges Granulat, insbesondere ein Metallpulver (z.B. Kupferpulver) oder ein Kohlenstoffpulver zugemischt sein.

In einer ersten Ausführungsform handelt es sich bei dem von der Steuereinrichtung zu betätigenden Aktor um eine Kartentaschenbeleuchtung, d.h. um eine oder mehrere Lampen (insbesondere in Form von Leuchtdioden), die den Innenraum einer in die Türinnenverkleidung eingelassenen Kartentasche beleuchten. Die zugehörige Sensorelektrode ist hierbei insbesondere derart an dem Türmodul angebracht, das sie in montiertem Zustand dicht an eine Innenwand der Kartentasche angrenzt. Durch die derart angeordnete Sensorelektrode wird die Hand eines Fahrzeugnutzers dann detektiert, wenn sie in die Kartentasche eingeführt wird. Die die Sensorelektrode umfassende Steuereinrichtung ist hierbei vorzugsweise als kapazitiver Näherungssensor ausgebildet, der die durch die Annäherung der Hand verursachte Änderung der zwischen der Sensorelektrode und Masse gebildeten elektrischen Kapazität misst, und bei hinreichender Abweichung der gemessenen Kapazität von einem vorgegebenen Sollwert die Kartentaschenbeleuchtung für eine bestimmte Zeitspanne einschaltet.

In einer weiteren Ausführungsform der Erfindung handelt es sich bei dem von der Steuereinrichtung zu betätigenden Aktor um einen Stellmotor zur Verstellung eines Innen- und Außenspiegels. Die dieser Steuereinrichtung zugeordnete Sensorelektrode ist vorzugsweise derart an dem Türmodul angeordnet, dass die Sensorelektrode zumindest näherungsweise mit einer an einer Front- oder Innenseite der Türinnenverkleidung markierten Bedienfläche fluchtet. Als Frontseite oder Innenseite ist hierbei diejenige Seite der Türinnenverkleidung bezeichnet, die im eingebauten Zustand (bei geschlossener Tür) dem Fahrzeuginnenraum zugewandt ist. Die Bedienfläche kann hierbei - bei einer Türinnenverkleidung mit lederner oder textiler Frontfläche - aufgestickt sein. Ferner kann die Bedienfläche auch aufgedruckt, durch andersartige Farbe oder andersartiges Material, oder in sonstiger Weise von der Umgebung optisch abgehoben sein.

Die derart markierte Bedienfläche simuliert in Kombination der verdeckt dahinter angeordneten Sensorelektrode einen Schalter, der aber - im Gegensatz zu einem üblichen, elektromechanischen Schalter - ohne bewegliche Teile auskommt und somit verschleißarm ist.

Die Sensorelektrode detektiert die Annäherung eines Fingers eines Fahrzeugnutzers, wobei die Steuereinrichtung hierzu wiederum vorzugsweise ein kapazitives Detektionsprinzip nutzt. Vorzugsweise umfasst die zur Verstellung eines Innen- oder Außenspiegels vorgesehene Steuereinrichtung mehrere Sensorelektroden, von denen jede jeweils einer von mehreren Verstellrichtungen des Spiegels zugeordnet ist. Optional kann die Steuereinrichtung weitere Sensorelektroden umfassen, über die zwischen verschiedenen zu verstellenden Spiegeln (z.B. linker Außenspiegel, rechter Außenspiegel und Rückspiegel) ausgewählt werden kann.

In einer weiteren Ausführungsform ist der von der Steuereinrichtung zu betätigende Aktor ein Fensterheberantrieb. Hierbei handelt es sich insbesondere um denjenigen Fensterheberantrieb, der in dasselbe Türmodul integriert ist wie die Sensorelektrode. Zusätzlich oder alternativ kann durch die Steuereinrichtung aber auch ein Fensterheberantrieb eines anderen Türmoduls, und entsprechend einer anderen Fahrzeugtür angesteuert werden.

Die zur Ansteuerung des Fensterheberantriebs vorgesehen Steuereinrichtung umfasst vorzugsweise zwei Sensorelektroden pro anzusteuerndem Fensterheberantrieb, von denen jede einer anderen Stellrichtung ("Heben", "Senken") zugeordnet ist. Vorzugsweise sind - zumindest in dem der Fahrertür eines Kraftfahrzeugs zugeordneten Türmodul - acht Sensorelektroden vorgesehen, die die Ansteuerung aller vier Fensterheber des Kraftfahrzeugs in jeweils beiden Stell-richtungen ermöglichen. Die oder jede Steuerelektrode der Steuereinrichtung ist hierbei wiederum bevorzugt derart an dem Türmodul angebracht, dass sie mit einer entsprechenden, markierten Bedienfläche an der Frontseite der Türinnenverkleidung fluchtet. Auch diese Variante der Steuereinrichtung ist vorzugsweise nach Art eines kapazitiven Näherungssensors ausgebildet.

Um die Detektionsgenauigkeit zu verbessern, kann die Sensorelektrode optional von mindestens einer Abschirmelektrode flankiert sein. Die Abschirmelektrode kann hierbei hinsichtlich ihrer Flächenausdehnung parallel zu der Sensorelektrode angeordnet sein, wobei die Sensorelektrode von der Abschirmelektrode vorzugsweise durch einen elektrische isolierende Lackschicht galvanisch getrennt ist. Die Abschirmelektrode ist in dieser Ausführung vorzugsweise zwischen dem Türmodul und der Sensorelektrode angeordnet. Alternativ hierzu kann die Abschirmelektrode auch auf der von dem Fahrzeuginnenraum im Montagezustand abgewandten Rückseite des Türmoduls angeordnet sein, so dass das Türmodul zwischen der Sensorelektrode und der Abschirmelektrode sandwichartig eingefasst ist. Zusätzlich oder alternativ hierzu kann auch eine seitlich neben der Sensorelektrode angeordnete Abschirmelektrode vorgesehen sein. Die Abschirmelektrode ist dabei insbesondere derart ausgebildet, dass sie die Sensorelektrode ringförmig oder zumindest von drei Seiten umgibt.

Die oder jede Abschirmelektrode wird durch die Steuereinrichtung vorzugsweise entweder auf Massenpotential oder auf ein mit dem Potential der Sensorelektrode mitgeführten Potential gehalten.

In zweckmäßiger Ausführung umfasst die Steuereinrichtung zusätzlich zu der mindestens einen Sensorelektrode eine mit der oder jeder Sensorelektrode verschaltete Steuereinheit, die zur Ansteuerung des Aktors in Abhängigkeit eines Sensorsignals der Sensorelektrode eingerichtet ist. Die Steuereinheit umfasst vorzugsweise einen Mikrokontroller mit einem darauf softwaretechnisch implementierten Steuerprogramm zur Auswertung des Sensorsignals sowie zur Ansteuerung des Aktors in Abhängigkeit des Auswertungsergebnisses.

Die Steuereinheit ist zweckmäßigerweise an demselben Türmodul angebracht, an dem auch die oder jede zugeordnete Sensorelektrode angebracht ist. Dies ermöglicht insbesondere, die Steuereinrichtung (die die oder jede Sensorelektrode und die Steuereinheit umfasst) bereits mit der Vorfertigung des Türmoduls vorzukonfektionieren (insbesondere zu verdrahten und zu prüfen).

In einer sowohl einfach herstellbaren als auch verschleißfesten Ausführungsvariante wird die Sensorelektrode mit der zugehörigen Steuereinheit vorzugsweise über eine Leiterbahn "verdrahtet" (d.h. leitfähig verbunden), die in den Träger integriert ist. Für die Herstellung der Leiterbahn kann jedes der vorstehend im Zusammenhang mit der Sensorelektrode beschriebenen Verfahren herangezogen werden. Insbesondere wird die Leiterbahn vorzugsweise einstückig mit der zugehörigen Sensorelektrode hergestellt.

In bevorzugter Ausführung sind an dem Türmodul mehrere Steuervorrichtungen mit jeweils zugeordneten Sensorelektroden zur Ansteuerung mehrerer Aktoren angeordnet. So sind an dem Träger des Türmoduls insbesondere
- eine erste Sensorelektrode einer ersten kapazitiven oder induktiven Steuereinrichtung zur berührungslosen Betätigung eines ersten Aktors im Kraftfahrzeug, sowie
- mindestens eine zweite Sensorelektrode einer zweiten kapazitiven oder induktiven Steuereinrichtung zur berührungslosen Betätigung eines zweiten Aktors im Kraftfahrzeug
vorgesehen. Um die vorhandenen Hardwareressourcen synergetisch zu nutzen, und hierdurch sowohl Gewicht, als auch Energieverbrauch und Herstellungsaufwand zu minimieren, ist mehreren dieser Steuereinrichtungen in zweckmäßiger Ausführung eine einzige, gemeinsame Steuereinheit zugeordnet. Insbesondere ist vorgesehen, dass alle an dem Träger angebrachten Sensorelemente, die beispielsweise teils zur Betätigung des Fensterheberantriebs, und anderenteils zur Steuerung der Kartentaschenbeleuchtung dienen können, mit der Fensterhebersteuerung als gemeinsamer Steuereinheit verschaltet sind.

Nachfolgend werden Ausführungsbeispiele der Erfindung anhand einer Zeichnung näher erläutert. Darin zeigen:
- Fig. 1: in Draufsicht die Innenseite (d.h. die bei geschlossener Tür einem Fahrzeuginnenraum zugewandte Seite) einer (Seiten-)Tür eines Kraftfahrzeugs, mit einem Türkörper und einem daran befestigten Türmodul bei abgenommener Türinnenverkleidung,
- Fig. 2: in einem schematischen Blockschaltbild fünf in dem Türmodul gemäß Fig. 1 integrierte Steuereinrichtungen zur berührungslosen Betätigung der vier Fensterheber des Kraftfahrzeugs bzw. zur berührungslosen Betätigung einer Kartentaschenbeleuchtung, wobei sich die fünf Steuereinrichtungen eine gemeinsame Steuereinheit teilen,
- Fig. 3: in perspektivischer Darstellung einen Träger des Türmoduls gemäß Fig. 1,
- Fig. 4: in einem schematischen Querschnitt grob vereinfacht die Tür gemäß Fig. 1 mit dem an dem Türkörper befestigten Türmodul sowie mit einer dem Türmodul fahrzeuginnenseitig vorgeblendeten Türinnenverkleidung, an der eine Kartentasche ausgeformt ist,
- Fig. 5: in einem vergrößerten Ausschnitt V gemäß Fig. 4 den Träger des Türmoduls mit einer darin integrierten Sensorelektrode der zur Betätigung der Kartentaschenbeleuchtung vorgesehenen Steuereinrichtung, und
- Fig. 6: in Darstellung gemäß Fig. 5 den Träger mit einer alternativ ausgebildeten Sensorelektrode.

Einander entsprechende Teile und Größen sind in allen Figuren stets mit gleichen Bezugszeichen versehen.

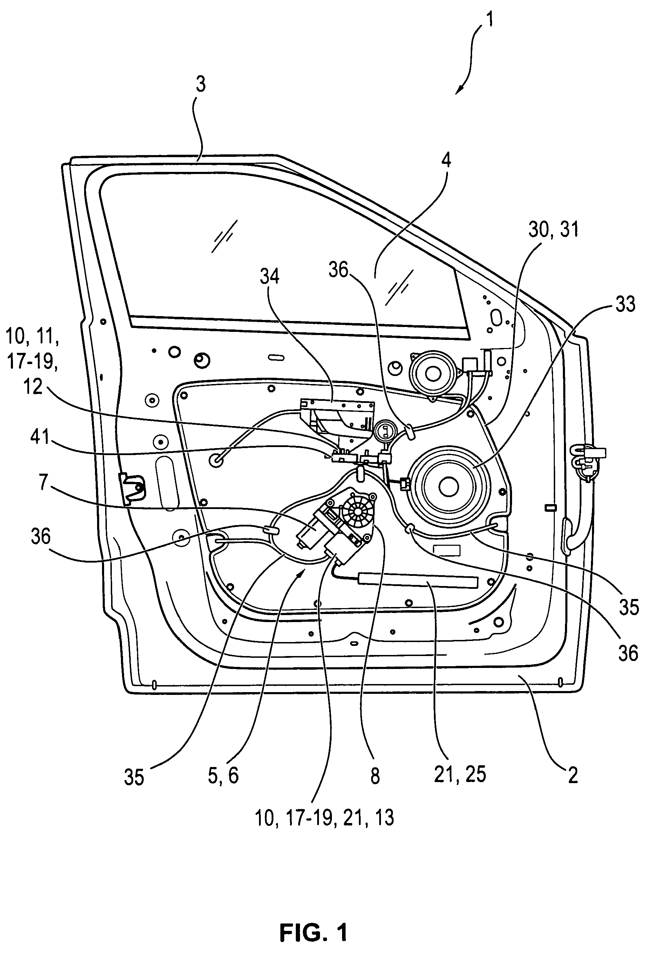

In Fig. 1 ist eine (Seiten-)Tür 1 eines Kraftfahrzeugs dargestellt, bei der es sich beispielsweise um die Fahrertür des Kraftfahrzeugs handelt. Die Tür 1 umfasst einen (auch als Türkarosserie bezeichneten) Türkörper 2 aus miteinander verschweißten Profilblechen, der auch die Außenhaut der Tür 1 bildet. In einem Fensterrahmen 3 des Türkörpers 2 ist eine (Fenster-)Scheibe 4 eingesetzt, die auf übliche Weise in vertikaler Richtung reversibel zwischen einer angehobenen Schließstellung und einer abgesenkten Öffnungsstellung verschiebbar ist.

Zur automatischen Verstellung der Scheibe 4 zwischen der Öffnungsstellung und der Schließstellung ist die Tür 1 mit einem elektrischen Fensterheber 5 versehen. Der Fensterheber 5 umfasst einen (Fensterheber-)Antrieb 6, der seinerseits aus einem Elektromotor 7 mit vorgeschaltetem Untersetzungsgetriebe 8 gebildet ist. Bei dem Fensterheber 5 handelt es sich um einen an sich gewöhnlichen Seilzug-Fensterheber, bei dem der Antrieb 6 über einen Seilzug auf die Scheibe 4 wirkt. Der (in Fig. 1 nicht sichtbare) Seilzug ist hierbei über eine Wickeltrommel mit der Abtriebsseite des Untersetzungsgetriebes 8, sowie über Mitnehmer mit der Scheibe 4 gekoppelt.

Zur Ansteuerung des Fensterheberantriebs 6 ist eine Steuereinrichtung 10 in der Tür 1 integriert.

Die Steuereinrichtung 10 ist als kapazitiver Näherungssensor zur berührungslosen Betätigung des Fensterheberantriebs 6 ausgebildet. Sie umfasst zwei durch jeweils eine Sensorelektrode 11 und 12 gebildete Befehlsgeber sowie eine Steuereinheit 13, die dazu eingerichtet ist, die über die Sensorelektroden 11 und 12 erzeugten Betätigungssignale zu erkennen und den Fensterheberantrieb 6 entsprechend anzusteuern. Die beiden Sensorelektroden 11 und 12 erzeugen dabei Betätigungssignale für die Verstellung der Scheibe 4 in unterschiedlichen Stellrichtungen ("Heben" und "Senken"). Konkret kann durch einen Fahrzeugnutzer über die Sensorelektrode 11 ein "Hub-Signal" erzeugt werden, aufgrund dessen die Steuereinheit 13 den Antrieb 6 zum Heben der Scheibe 4 veranlasst. Ebenso kann über die Sensorelektrode 12 ein "Senk-Signal" gegeben werden, aufgrund dessen die Steuereinheit 13 den Antrieb 6 zum Absenken der Scheibe 4 ansteuert.

Die Steuereinheit 13 ist im Wesentlichen durch einen Mikrocontroller gebildet, dessen Funktionalität softwaretechnisch in Form eines Steuerprogramms 14 implementiert ist. Wie aus Fig. 1 ersichtlich ist, ist die Steuereinheit 13 auf ein Getriebegehäuse des Antriebs 6 aufgesteckt.

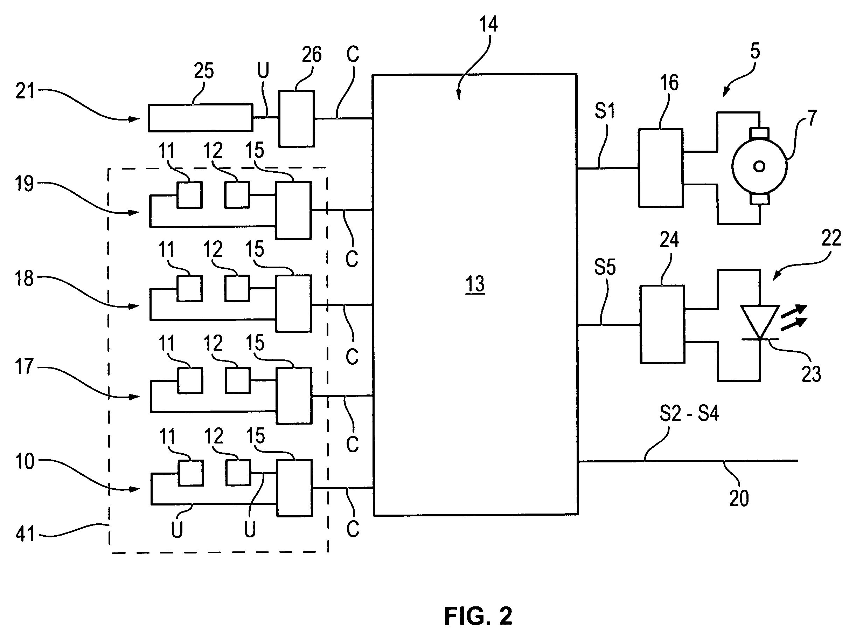

Im Betrieb der Steuereinrichtung 10 wird von der Steuereinheit 13 gemäß Fig. 2 über eine vorgeschaltete Treiberschaltung 15 eine elektrische Wechselspannung U an die Sensorelektroden 11 und 12 angelegt, unter deren Wirkung sich in einem den Sensorelektroden 11 und 12 vorgelagerten Raum ein elektrisches Feld ausbildet. Zwischen jeder der Sensorelektroden 11 bzw. 12 einerseits und Masse andererseits wird hierbei jeweils ein elektrischer Kondensator gebildet, dessen elektrische Kapazität durch die Treiberschaltung 15 bestimmt wird. Die Treiberschaltung 15 leitet hierbei ein zu der gemessenen Kapazität proportionales (Kapazitäts-) Messsignal C an die Steuereinheit 13.

Die beiden Sensorelektroden 11 und 12 werden hierbei vorzugsweise im Zeitmultiplexbetrieb, d.h. zeitlich alternierend betrieben, so dass zu jedem Zeitpunkt nur entweder das von der Sensorelektrode 11 oder das von Sensorelektrode 12 ausgehende elektrische Feld präsent ist, wodurch die Kapazitäten der Sensorelektroden 11 und 12 (gegenüber Masse) entkoppelt voneinander gemessen werden können.

Die Funktion der Steuereinheit 10 beruht auf dem physikalischen Effekt, dass bei Einbringen von menschlichem Körpergewebe in das elektrische Feld die zwischen der jeweiligen Sensorelektrode 11 bzw. 12 und Masse gebildete Kapazität signifikant beeinflusst wird. Insbesondere verursacht die Annäherung eines Fingers eines Fahrzeugbenutzers an die jeweilige Sensorelektrode 11 oder 12 einen signifikanten Anstieg des an der jeweiligen Sensorelektrode 11 bzw. 12 messbaren Kapazitätswertes, und eine entsprechende Änderung des von der Treiberschaltung 15 ausgegebenen Messsignals C. Durch das in der Steuereinheit 13 implementierte Steuerprogramm 14 wird das Messsignal C mit hinterlegten Schwellwerten verglichen. Die Steuereinheit 13 veranlasst hierbei - durch Abgabe eines Stellsignals S1 an einem dem Elektromotor 7 vorgeschalteten Motortreiber 16 - und entsprechenden Betrieb des Elektromotors 7 - das Heben bzw. Senken der Scheibe 4, wenn der jeweilige Schwellwert überschritten wird.

Zusätzlich zu der Steuereinrichtung 10 sind in der Tür 1 weitere Steuereinrichtungen 17, 18 und 19 integriert. Diese weiteren Steuereinrichtungen 17 bis 19 dienen zur Ansteuerung eines jeweils weiteren Fensterhebers, der einer jeweils weiteren Tür des Kraftfahrzeugs zugeordnet ist. Jede der weiteren Steuereinrichtungen 17 bis 19 umfasst - in gleicher Weise wie die Steuereinrichtung 10 - jeweils eine Sensorelektrode 11 zur Erzeugung eines Hub-Signals und eine Sensorelektrode 12 zur Erzeugung eines Senk-Signals. Jede der Steuereinrichtungen 17 bis 19 umfasst des Weiteren - ebenso in gleicher Weise wie die Steuereinrichtung 10 - eine mit den zugehörigen Sensorelektroden 11 und 12 verschaltete Treiberschaltung 15. Die Treiberschaltungen 15 der Steuereinrichtung 17 bis 19 sind hierbei mit der Steuereinheit 13 verschaltet und liefern jeweils ein Kapazitätsmesssignal C an die Steuereinheit 13, wobei diese anhand des Kapazitätsmesssignals C - in gleicher Weise wie im Fall der Steuereinrichtung 10 - über das Heben oder Senken der jeweils zugeordneten Scheibe entscheidet. Entsprechende Stellsignale S2 bis S4 gibt die Steuereinheit 13 über einen Bus 20 (beispielsweise einen sogenannten CAN-Bus) an den Motortreiber des jeweils betroffenen, weiteren Fensterhebers ab.

Wie aus Fig. 2 zu erkennen ist, ist in der Tür 1 außerdem eine weitere Steuereinrichtung 21 integriert, die zur Ansteuerung einer Kartentaschenbeleuchtung 22 dient. Die Kartentaschenbeleuchtung 22 wird gebildet durch eine Gruppe von Leuchtdioden 23 (von denen in Fig. 2 aus Vereinfachungsgründen lediglich eine Leuchtdiode 23 dargestellt ist) sowie durch einen den Leuchtdioden 23 vorgeschalteten Diodentreiber 24.

Die zur Ansteuerung der Kartentaschenbeleuchtung 22 vorgesehene Steuereinrichtung 21 ist ebenfalls als kapazitiver Näherungssensor ausgebildet. Entsprechend umfasst die Steuereinrichtung 21 eine Sensorelektrode 25 mit einer vorgeschalteten Treiberschaltung 26, die vom Aufbau und der Funktion her im Wesentlichen den Treiberschaltungen 15 entspricht. Die Treiberschaltung 26 ist auch - wie die Treiberschaltungen 15 - zur Zuführung des (Kapazitäts-)Messwerts C mit der Steuereinheit 13 verschaltet. Die Steuereinrichtungen 10, 17 bis 19 und 21 teilen sich somit die gemeinsame Steuereinheit 13.

Auch im Rahmen der Steuereinrichtung 21 vergleicht die Steuereinheit 13 den von der Treiberschaltung 26 zugeführten Kapazitätsmesswert C mit einem hinterlegten Schwellwert und schaltet die Kartentaschenbeleuchtung 22 - durch Abgabe eines entsprechenden Stellsignals S5 an den Diodentreiber 24 für eine voreingestellte Zeitspanne an, wenn der Schwellwert überschritten wird.

Zusätzlich zu den vorstehend beschriebenen Steuereinrichtungen 10,17 bis 19 und 21 können in der Tür 1 weitere Steuereinrichtungen vorgesehen sein, insbesondere Steuereinrichtungen zur automatischen Verstellung von Innen- und/oder Außenspiegeln des Kraftfahrzeugs. Auch diese gegebenenfalls vorhandenen weiteren Steuereinrichtungen nutzen vorzugsweise die Steuereinheit 13 des Fensterhebers 5 als gemeinsame Steuereinheit mit.

Um eine vereinfachte Montage der Tür 1 zu ermöglichen, sind zumindest die meisten Funktionskomponenten der Tür 1, insbesondere also die Steuereinrichtungen 10, 17 bis 19 und 21 mit der gemeinsamen Steuereinheit 13, der Fensterheber 5 und die Kartentaschenbeleuchtung 22 in einem Türmodul 30 integriert, das als Ganzes fern von dem Kraftfahrzeug vormontiert und erst im Zuge der Endmontage des Kraftfahrzeugs mit dem Türkörper 2 durch Verclipsung, Verschweißung oder in anderer Weise verbunden wird.

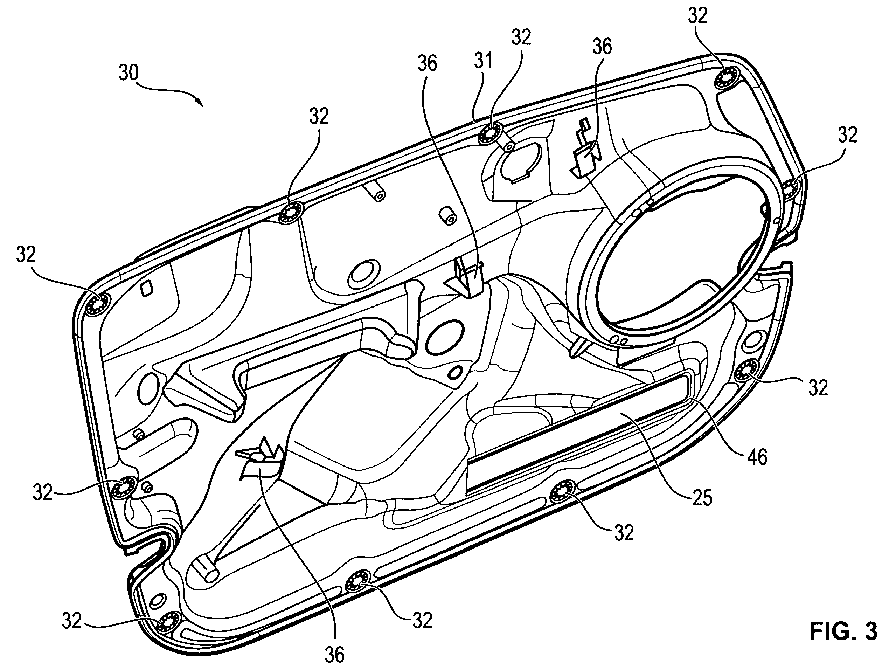

Zentraler Bestandteil dieses Türmoduls 30 ist ein flächiger, profilierter Träger 31, der vorzugsweise durch ein großflächiges Spritzgussteil aus Kunststoff gebildet ist. Der in Fig. 3 nochmals isoliert dargestellte Träger 31 ist an seinem Umfang mit einer Anzahl von Befestigungspunkten 32 versehen, an denen der Träger 31 an dem Türkörper 2 befestigbar ist.

An dem Träger 31 sind des Weiteren Befestigungselemente (insbesondere Durchführungen und Schraubdome) vorgesehen, an denen im Montagezustand der Fensterheberantrieb 6 und die Sensorelektroden 11, 12 und 25 befestigt sind. Zusätzlich zu diesen Funktionskomponenten ist an dem Träger 31 insbesondere ein Bordlautsprecher 33 sowie ein Türinnengriff 34 befestigt. Der Türinnengriff 34 kann alternativ aber auch an der Türinnenverkleidung befestigt sein.

Die auf dem Träger 31 befestigten Funktionskomponenten werden vorzugsweise bereits in Vormontage elektrisch mit Versorgungs- und Signalleitungen 35 kontaktiert. Bei dem Ausführungsbeispiel gemäß Fig. 1 bis 5 sind diese Versorgungs- und Signalleitungen 35 durch gewöhnliche, vom Träger 31 ausgelöste (Draht-) Leiter gebildet. Um eine definierte Kabelführung zu ermöglichen, sind an den Träger 31 hierbei Kabelführungselemente 36 in Form von Haken und/oder Ösen angeformt.

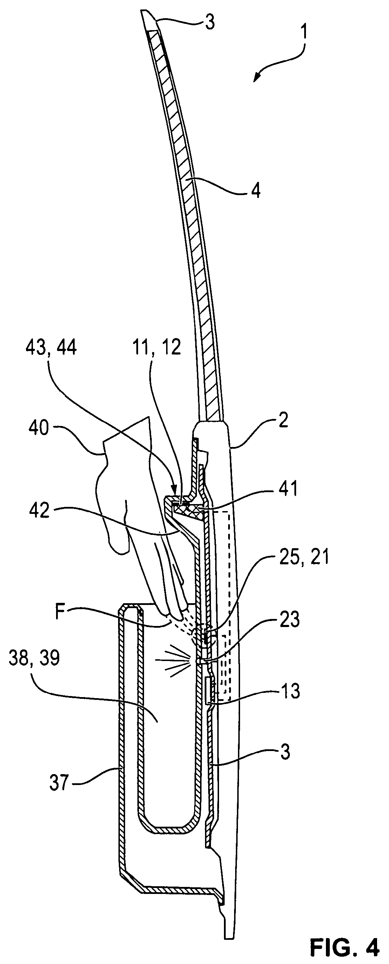

Fig. 4 zeigt die Tür 1 in einer schematisch vereinfachten, teilgeschnittenen Darstellung. Aus dieser Darstellung wird insbesondere ersichtlich, dass dem Türkörper 2 und dem daran befestigten Türmodul 30 innenseitig eine Türinnenverkleidung 37 vorgeblendet ist. Wie aus der Fig. 4 weiterhin ersichtlich ist, ist die Türinnenverkleidung 37 in einem unteren Bereich zu einer (aus darstellungstechnischen Gründen) übergroß dargestellten Kartentasche 38 ausgeformt. Die Leuchtdioden 23 sind hierbei derart an dem Träger 31 des Türmoduls 30 angebracht, dass sie im Bereich einer Öffnung oder eines Fensters in einem die Innenwand der Kartentasche 38 bildenden Bereich der Türinnenverkleidung 37 angeordnet sind und in angeschaltetem Zustand durch diese Öffnung bzw. dieses Fenster einen Innenraum 39 der Kartentasche ausleuchten. Die zugehörige Sensorelektrode 25 der Steuereinrichtung 21 ist derart an dem Träger 31 angebracht, dass sie den Innenraum 39 der Kartentasche 38 flankiert und eine Hand 40 eines Fahrzeugnutzers detektiert, wenn diese in den Innenraum 39 eingeführt wird. Somit wird die Kartentaschenbeleuchtung 22 dann angeschaltet, wenn der Fahrzeugnutzer die Hand 40 in die Kartentasche 38 einführt. Alternativ können die Leuchtdioden 23 auch auf der Innenverkleidung befestigt sein.

Die Sensorelektroden 11 und 12 der Steuereinrichtungen 10 und 17 bis 19 sind auf der Oberseite eines Bedienblocks 41 angeordnet, der von einer Innenfläche des Trägers 31 nach innen (d.h. in montiertem Zustand in Richtung des Fahrzeuginnenraums) absteht. Der Bedienblock 41 kann hierbei wahlweise einstückig mit dem Träger 31 ausgebildet oder - wie in Fig. 4 dargestellt - als separates Bauteil gefertigt sein, das mit dem Träger 31 zum Beispiel durch Verschraubung verbunden ist.

Wie aus Fig. 4 erkennbar ist, ragt der Bedienblock 41 in eine korrespondierende Auswölbung 42 der Türinnenverkleidung 37 hinein, so dass die Sensorelektroden 11 und 12 jeweils dicht unter einer Oberseite 43 der Auswölbung 42 liegen. Jeweils in Deckung mit jeder der Sensorelektroden 11 und 12 ist hierbei auf der Oberseite 43 der Auswölbung 42 eine - durch kontrastierende Farbgebung und/oder durch ein aufgedrucktes Bediensymbol (zum Beispiel einem Pfeil) - markierte Bedienfläche (nachfolgend: Bedienfeld 44) aufgebracht. Jedes Bedienfeld 44 gibt dem Fahrzeugnutzer hierbei einen Hinweis auf die Lage der jeweils zugeordneten Sensorelektrode 11 oder 12. Die Bedienfelder 44 und die zugeordneten Sensorelektroden 11 und 12 sind hierbei derart hinsichtlich Lage und Größe aufeinander abgestimmt, dass der Fahrzeugnutzer durch Annäherung eines Fingers an das jeweilige Bedienfeld 44 die jeweils zugeordnete Sensorelektrode 11 oder 12 zur Erzeugung eines Stellbefehls aktivieren kann.

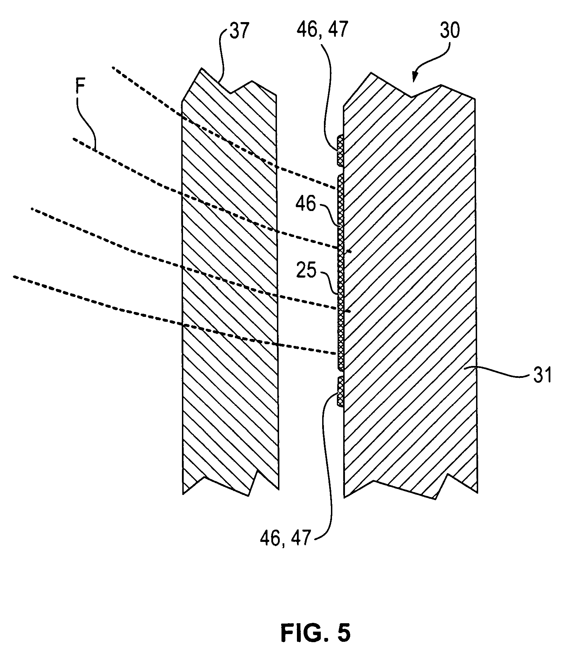

In dem in den Fig. 1 bis 5 dargestellten Ausführungsbeispiel ist die Sensorelektrode 25 der Steuereinrichtung 21 durch eine Metallfolie gebildet, die flächig auf der Innenseite des Trägers 31 flächig aufgeklebt ist. Aus den Fig. 2 und 5 wird ersichtlich, dass die Sensorelektrode 25 von einer Abschirmelektrode 47 flankiert ist, die die Sensorelektrode 25 von drei Seiten mit geringem Abstand umgibt. Die Abschirmelektrode 47 wird hierbei von der Steuereinheit 13 auf ein Massepotential oder auf ein anderes sich vom Potential der Sensorelektrode 25 unterscheidendes Potential gelegt, um die Sensorelektrode 25 gegen Störeinflüsse abzuschirmen. In gleicher Weise wie die Sensorelektrode 25 (wahlweise mit oder ohne zugeordnete Abschirmelektroden) sind auch die Sensorelektroden 11 und 12 der Steuereinrichtungen 10 und 17 bis 19 ausgebildet.

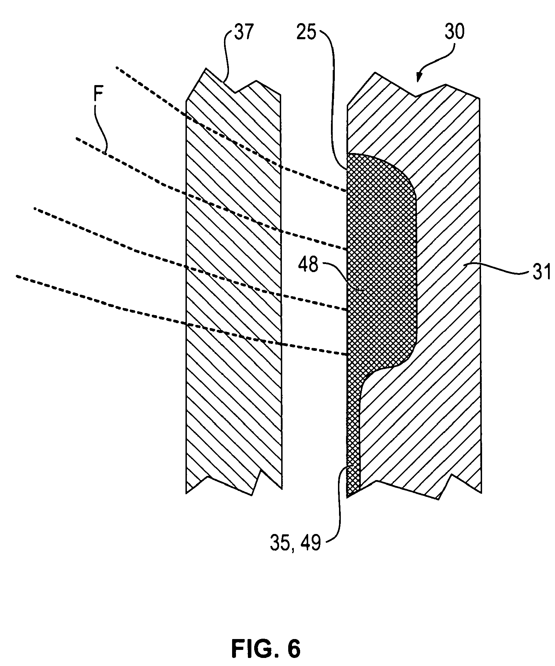

In einer in Fig. 6 dargestellten alternativen Ausführung des Türmoduls 30 ist die Sensorelektrode 25 durch einen leitfähigen Kunststoffbereich 48 gebildet, der in den Träger 31 eingebettet ist. Dieser Kunststoffbereich 48 ist insbesondere durch lokale Zumischung von Metallpulver zum Kunststoffmaterial des Trägers 31 gebildet.

Das Ausführungsbeispiel gemäß Fig. 6 unterscheidet sich von dem zuvor beschriebenen Ausführungsbeispiel ferner dadurch, dass die Versorgungs- und Signalleitungen 35 nicht durch Drahtleiter (Kabel), sondern durch Leiterbahnen 49 aus elektrisch leitfähigem, in das Material des Trägers 31 eingebetteten Kunststoff gebildet sind. Die Versorgungs- und Signalleitungen 35 sind hier also einstückig mit dem Träger 31 ausgebildet. Anstelle von leitfähigem Kunststoff könnten die Leiterbahnen 49 allerdings auch durch aufgeklebte oder in sonstiger Weise mit dem Träger 31 verbundenen Metallfolienstreifen oder durch lokale Beschichtung der Trägeroberfläche mit einem leitfähigen Material gebildet sind.

Die Erfindung wird nicht durch die vorstehend beschriebenen Ausführungsbeispiele. Vielmehr können weitere Ausführungsformen der Erfindung von dem Fachmann aus den vorstehenden Erläuterungen abgeleitet werden. Insbesondere können die Einzelmerkmale der beiden vorstehend beschriebenen Ausführungsbeispiele im Rahmen der durch die anhängenden Ansprüche definierte Erfindung auch in anderer Weise miteinander kombiniert werden.

**Bezugszeichenliste**

| | | | |
|---|---|---|---|
| 1 | (Seiten-)Tür | 34 | Türinnengriff |
| 2 | Türkörper | 35 | (Versorgungs- und |
| 3 | Fensterrahmen | | Signal-)Leitung |
| 4 | (Fenster-)Scheibe | 36 | Kabelführungselement |
| 5 | Fensterheber | 37 | Türinnenverkleidung |
| 6 | (Fensterheber-)Antrieb | 38 | Kartentasche |
| 7 | Elektromotor | 39 | Innenraum |
| 8 | Untersetzungsgetriebe | 40 | Hand |
| 10 | Steuereinrichtung | 41 | Bedienblock |
| 11 | Sensorelektrode | 42 | Auswölbung |
| 12 | Sensorelektrode | 43 | Oberseite |
| 13 | Steuereinheit | 44 | Bedienfeld |
| 14 | Steuerprogramm | 46 | Metallfolie |
| 15 | Treiberschaltung | 47 | Abschirmelektrode |
| 16 | Motortreiber | 48 | (leitfähiger) Kunststoffbereich |
| 17 | Steuereinrichtung | 49 | Leiterbahn |
| 18 | Steuereinrichtung | | |
| 19 | Steuereinrichtung | C | (Kapazitäts-)Messsignal |
| 20 | Bus | F | (elektrisches) Feld |
| 21 | Steuereinrichtung | S1..S5 | Stellsignal |
| 22 | Kartentaschenbeleuchtung | U | Wechselspannung |
| 23 | Leuchtdiode | | |
| 24 | Diodentreiber | | |
| 25 | Sensorelektrode | | |
| 26 | Treiberschaltung | | |
| 30 | Türmodul | | |
| 31 | Träger | | |
| 32 | Befestigungspunkt | | |
| 33 | Bordlautsprecher | | |

## Patentansprüche

1. Türmodul (30) für eine Tür (1) eines Kraftfahrzeugs, mit einem Träger (31) zur Aufnahme eines Fensterheberantriebs (6) sowie mit Befestigungspunkten (32), an denen das Türmodul (30) an der zugeordneten Tür (1) befestigbar ist,
**dadurch gekennzeichnet,**
**dass** an dem Träger (31) mindestens eine Sensorelektrode (11,12,25) einer kapazitiven und/oder induktiven Steuereinrichtung (10,17-19,21) zur berührungslosen Betätigung eines Aktors (6,23) in dem Kraftfahrzeug an- oder eingebracht ist.

2. Türmodul (30) nach Anspruch 1,
**dadurch gekennzeichnet,**
**dass** die Sensorelektrode (11,12,25) durch eine Folie aus elektrisch leitfähigem Material gebildet ist, die flächig auf dem Träger (31) aufgebracht ist.

3. Türmodul (30) nach Anspruch 1,
**dadurch gekennzeichnet,**
**dass** die Sensorelektrode (11,12,25) durch eine auf den Träger (31) aufgebrachte, leitfähige Beschichtung gebildet ist.

4. Türmodul (30) nach Anspruch 1,
**dadurch gekennzeichnet,**
**dass** die Sensorelektrode (11,12,25) durch einen elektrisch leitfähigen Kunststoffbereich (47) des Trägers (31) gebildet ist.

5. Türmodul (30) nach einem der Ansprüche 1 bis 4,
**dadurch gekennzeichnet,**
**dass** der von der Steuereinrichtung (21) zu betätigende Aktor eine Kartentaschenbeleuchtung (22) ist.

6. Türmodul (30) nach einem der Ansprüche 1 bis 4,
**dadurch gekennzeichnet,**
**dass** der von der Steuereinrichtung zu betätigende Aktor ein Stellmotor zur Verstellung eines Innen- oder Außenspiegels ist.

7. Türmodul (30) nach einem der Ansprüche 1 bis 6,
**dadurch gekennzeichnet,**
**dass** der von der Steuereinrichtung (10,17-19) zu betätigende Aktor ein Fensterheberantrieb (6) ist.

8. Türmodul (30) nach einem der Ansprüche 1 bis 7,
**dadurch gekennzeichnet,**
**dass** die Sensorelektrode (25) von einer auf dem Träger (31) angebrachten Abschirmelektrode (46) zumindest abschnittsweise flankiert wird.

9. Türmodul (30) nach einem der Ansprüche 1 bis 8,
**dadurch gekennzeichnet,**
**dass** die Steuereinrichtung (10,17-19,31) eine mit der Sensorelektrode (11,12,25) verschaltete Steuereinheit (13) zur Ansteuerung des Aktors (6,23) in Abhängigkeit eines Sensorsignals der Sensorelektrode (11,12,25) umfasst, die als Teil des Türmoduls (30) an dem Träger (31) angebracht ist.

10. Türmodul (30) nach Anspruch 9,
**dadurch gekennzeichnet,**
**dass** die Sensorelektrode (10,17-19,21) mit der Steuereinheit (13) über eine in den Träger (31) integrierte Leiterbahn (49) verschaltet ist.

11. Türmodul (30) nach Anspruch 9 oder 10,
**dadurch gekennzeichnet,**
**dass** an dem Träger (31) eine erste Sensorelektrode (11,12) einer ersten kapazitiven oder induktiven Steuereinrichtung (10,17-19) zur berührungslosen Betätigung eines ersten Aktors (6) im Kraftfahrzeug, und mindestens eine zweite Sensorelektrode (25) einer zweiten kapazitiven oder induktiven Steuereinrichtung (21) zur berührungslosen Betätigung eines zweiten Aktors (23) im Kraftfahrzeug angebracht sind, wobei die erste Steuereinrichtung (10,17-19) und die zweite Steuereinrichtung (21) die Steuereinheit (13) teilen.

## Claims

1. Door module (30) for a door (1) of a motor vehicle, having a carrier (31) to receive a window winder drive (6) as well as having fastening points (32) at which the door module (30) is able to be fastened to the allocated door (1),
**characterised in that**
at least one sensor electrode (11, 12, 25) of a capacitive and/or inductive control device (10, 17-19, 21) for contactless actuation of an actuator (6, 23) in the motor vehicle is attached to or inserted into the carrier (31).

2. Door module (30) according to claim 1,
**characterised in that**
the sensor electrode (11, 12, 25) is formed by a foil made from electrically conductive material, said foil being applied extensively to the carrier (31).

3. Door module (30) according to claim 1,
**characterised in that**
the sensor electrode (11, 12, 25) is formed by a conductive coating applied to the carrier (31).

4. Door module (30) according to claim 1,
**characterised in that**
the sensor electrode (11, 12, 25) is formed by an electrically conductive plastic region (47) of the carrier (31).

5. Door module (30) according to one of claims 1 to 4,
**characterised in that**
the actuator to be actuated by the control device (21) is a map pocket illumination (22).

6. Door module (30) according to one of claims 1 to 4,
**characterised in that**
the actuator to be actuated by the control device is a servomotor to adjust an inner or outer mirror.

7. Door module (30) according to one of claims 1 to 6,
**characterised in that**
the actuator to be actuated by the control device (10, 17-19) is a window winder drive (6).

8. Door module (30) according to one of claims 1 to 7,
**characterised in that**
the sensor electrode (25) is flanked, at least in sections, by a shielding electrode (46) which is attached to the carrier (31).

9. Door module (30),according to one of claims 1 to 8,
**characterised in that**
the control device (10, 17-19, 31) comprises a control unit (13) connected to the sensor electrode (11, 12, 25) to control the actuator (6, 23) depending on a sensor signal of the sensor electrode (11, 12, 25) which is attached to the carrier (31) as part of the door module (30).

10. Door module (30) according to claim 9,
**characterised in that**
the sensor electrode (10, 17-19, 21) is connected to the control unit (13) via a conductor path (49) integrated into the carrier (31).

11. Door module (30) according to claim 9 or 10,
**characterised in that**
a first sensor electrode (11, 12) of a first capacitive or inductive control device (10, 17-19) for contactless actuation of a first actuator (6) in the motor vehicle, and at least one second sensor electrode (25) of a second capacitive or inductive control device (21) for contactless actuation of a second actuator (23) in the motor vehicle are attached to the carrier (31), wherein the first control device (10, 17-19) and the second control device (21) share the control unit (13).

## Revendications

1. Module de portière (30) pour une portière (1) d'un véhicule automobile, comprenant un support (31) destiné à recevoir un entraînement de lève-vitre (6), ainsi que des points de fixation (32) au niveau desquels le module de portière (30) peut être fixé à la portière (1) associée,
**caractérisé**
**en ce que** dans ou sur le support (31) est rapporté ou intégré au moins une électrode de détecteur (11, 12, 25) d'un dispositif de commande capacitif et/ou inductif (10, 17-19, 21) pour l'actionnement sans contact d'un actionneur (6, 23) dans le véhicule automobile.

2. Module de portière (30) selon la revendication 1,
**caractérisé**
**en ce que** l'électrode de détecteur (11, 12, 25) est formée par un film en matériau électriquement conducteur, qui est appliqué en surface sur le support (31).

3. Module de portière (30) selon la revendication 1,
**caractérisé**
**en ce que** l'électrode de détecteur (11, 12, 25) est formée par un revêtement conducteur, qui est appliqué sur le support (31).

4. Module de portière (30) selon la revendication 1,
**caractérisé**
**en ce que** l'électrode de détecteur (11, 12, 25) est formée par une zone de matière plastique (47) électriquement conductrice, du support (31).

5. Module de portière (30) selon l'une des revendications 1 à 4,
**caractérisé**
**en ce que** l'actionneur à actionner par le dispositif de commande (21) est un éclairage (22) de vide-poche ou de porte-cartes.

6. Module de portière (30) selon l'une des revendications 1 à 4,
**caractérisé**
**en ce que** l'actionneur à actionner par le dispositif de commande est un moteur de réglage pour assurer le réglage d'un rétroviseur intérieur ou extérieur.

7. Module de portière (30) selon l'une des revendications 1 à 6,
**caractérisé**
**en ce que** l'actionneur à actionner par le dispositif de commande (10, 17-19) est un entraînement de lève-vitre (6).

8. Module de portière (30) selon l'une des revendications 1 à 7,
**caractérisé**
**en ce que** l'électrode de détecteur (25) est encadrée, au moins par secteurs, par une électrode de blindage (46) appliquée sur le support (31).

9. Module de portière (30) selon l'une des revendications 1 à 8,
**caractérisé**
**en ce que** le dispositif de commande (10, 17-19, 31) comprend une unité de commande (13), qui est en circuit avec l'électrode de détecteur (11, 12, 25) et est destinée à assurer la commande de l'actionneur (6, 23) en fonction d'un signal de détecteur de l'électrode de détecteur (11, 12, 25), et qui est rapportée sur le support (31) en tant que partie du module de portière (30).

10. Module de portière (30) selon la revendication 9,
**caractérisé**
**en ce que** l'électrode de détecteur (10, 17-19, 21) est en circuit avec l'unité de commande (13) par l'intermédiaire d'une piste conductrice (49) intégrée au support (31).

11. Module de portière (30) selon la revendication 9 ou la revendication 10,
**caractérisé**
**en ce que** sur le support (31) sont rapportées une première électrode de détecteur (11, 12) d'un premier dispositif de commande capacitif ou inductif (10, 17-19) pour l'actionnement sans contact d'un premier actionneur (6) dans le véhicule automobile, et au moins une deuxième électrode de détecteur (25) d'un deuxième dispositif de commande capacitif ou inductif (21) pour l'actionnement sans contact d'un deuxième actionneur (23) dans le véhicule automobile, le premier dispositif de commande (10, 17-19) et le deuxième dispositif de commande (21) se partageant l'unité de commande (13).
